# EUROPEAN PATENT APPLICATION

(11) **EP 4 576 154 A1**
(43) Date of publication of application: **25.06.2025**
(21) Application number: 23217561.2
(22) Date of filing: 18.12.2023
(51) Int. Cl.: H01J 37/02, H01J 37/14, H01J 37/28

(54) **SOURCE MODULE AND CHARGED PARTICLE-OPTICAL DEVICE**

(71) Applicant: ASML Netherlands B.V., 5500 AH Veldhoven (NL)
(72) Inventor: PEIJSTER, Jerry, Johannes, Martinus, 5500 AH Veldhoven (NL); KUIPER, Vincent, Sylvester, 5500 AH Veldhoven (NL); MA, Yue, 5500 AH Veldhoven (NL)
(74) Representative: ASML Netherlands B.V.

(57) **Abstract**

The present disclosure relates to a module 61 for a charged particle-optical device 40 configured to direct one or more primary beams 202 of charged particles toward a sample location along a beam path, the module comprising: a wall for a vacuum chamber; and an actuatable charged particle-optical element 270 configured to operate on charged particles directed along the beam path towards the sample location; wherein the actuatable charged particle-optical element is configured to be located outside the wall for the vacuum chamber and to be actuatable relative to the beam path in a direction across the primary beam and/or about an axis 205 across the primary beam.

## Description

### FIELD

The present disclosure relates to a source module, a charged particle-optical device, a charged particle-optical apparatus and a method for alignment for a charged particle-optical device.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment for example inspection and/or measurement of a surface of a substrate, or other object/material, is an important process during and/or after its manufacture.

Assessment tools, which herein are referred to as assessment systems, are known that use a charged particle beam to assess objects, which may be referred to as samples, for example to detect pattern defects. These systems typically use electron microscopy techniques, such as a scanning electron microscope (SEM). In a SEM, a primary electron beam of electrons at a relatively high energy is targeted with a final deceleration step to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface, a pattern assessment system (such as a pattern inspection system) may obtain an image representing characteristics of the material structure of the surface of the sample.

In applications such as charged particle systems (e.g., a SEM) different components, or modules, within the system are desirably aligned correctly with respect to each other during use. In some applications different modules to should be aligned to each other to within a few microns (e.g., 5 microns). Known processes for alignment require manual interaction, the system to be down for a long time (e.g. several days) for each adjustment and/or specialized personnel to perform an adjustment. This can be a challenging and time-consuming process, reducing productivity and increasing costs.

### SUMMARY

It is an object of the present disclosure to make alignment less manual or even fully automated, quicker and/or easier to perform.

According to an aspect of the invention, there is provided a module for a charged particle-optical device configured to direct one or more primary beams of charged particles toward a sample location along a beam path, the module comprising: a wall for a vacuum chamber; and an actuatable charged particle-optical element configured to operate on charged particles directed along the beam path towards the sample location; wherein the actuatable charged particle-optical element is configured to be located outside the wall for the vacuum chamber and to be actuatable relative to the beam path desirably in a direction across the primary beam and/or about an axis across the primary beam.

According to another aspect of the invention, there is provided a method for a charged particle-optical device configured to direct one or more primary beams of charged particles toward a sample along a beam path, the method comprising: directing charged particles along the beam path toward a sample; operating on the charged particles with an actuatable charged particle-optical element located outside a wall of the charged particle-optical device, the wall being for a vacuum chamber; and actuating the actuatable charged particle-optical element relative to the beam path.

According to another aspect of the invention, there is provided a method for aligning a plurality of primary beams within a charged particle-optical device for directing the plurality of primary beams along a beam path towards a sample location, the primary beams derived from a source beam generated by a source, the method comprising: directing charged particles in a source beam from a source towards a sample location; deriving a plurality of primary beams from the charged particles of the source beam; measuring an offset of the primary beams relative to a reference; and controlling an actuatable arrangement of the charged particle-optical device using the offset to align the primary beams with the reference, the controlling comprising actuating the actuatable arrangement to move a first component of the actuatable arrangement relative to the source and/or the reference.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam assessment apparatus.
**FIG. 2** is a schematic diagram illustrating an exemplary charged particle-optical apparatus that is part of the exemplary charged particle beam assessment apparatus of **FIG. 1****.**
**FIG. 3** is a schematic diagram of a charged particle-optical device that is part of the charged particle-optical apparatus of **FIG. 2****.**
**FIG. 4** is a schematic diagram of an alternative charged particle-optical device that is part of the charged particle-optical apparatus of **FIG. 2****.**
**FIG. 5** is a schematic diagram of an implementation of the charged particle-optical device of **FIG. 3****.**
**FIG. 6** is a schematic diagram illustrating field curvature and a stigmatism over a multi-beam.
**FIG. 7** is a schematic diagram of an actuatable charged particle-optical element that is part of the charged particle-optical apparatus of **FIG. 2****.**
**FIG. 8** is a schematic diagram of an alternative actuatable charged particle-optical element that is part of the charged particle-optical apparatus of **FIG. 2****.**
**FIG. 9** is a side-on diagram of the actuatable charged particle-optical element of **FIG. 7** or **FIG. 8****.**

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000^{th} of a human hair. Thus, it is not surprising that semiconductor IC manufacturing is a complex and time-consuming process, with hundreds of individual steps. Errors in even one step have the potential to dramatically affect the functioning of the final product. Even a single defect can cause device failure in certain situations. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a Scanning Electron Microscope (`SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused primary beams of electrons. Together at least the illumination apparatus, or illumination system, and the projection apparatus, or projection system, may be referred to together as the electron-optical device or column. The primary electrons interact with the sample and generate secondary electrons. The detection apparatus captures the secondary electrons from the sample as the sample is scanned so that the SEM can create an image of the scanned area of the sample. For high throughput assessment such as inspection, some of the assessment apparatuses use multiple primary beams, i.e. a multi-beam of electrons, that may be focused on the sample. The primary beams of the multi-beam may be referred to as sub-beams or beamlets. A multi-beam can scan different parts of a sample simultaneously. A multi-beam assessment apparatus can therefore assess a sample at a much higher speed than a single-beam assessment apparatus.

An implementation of a known multi-beam assessment apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

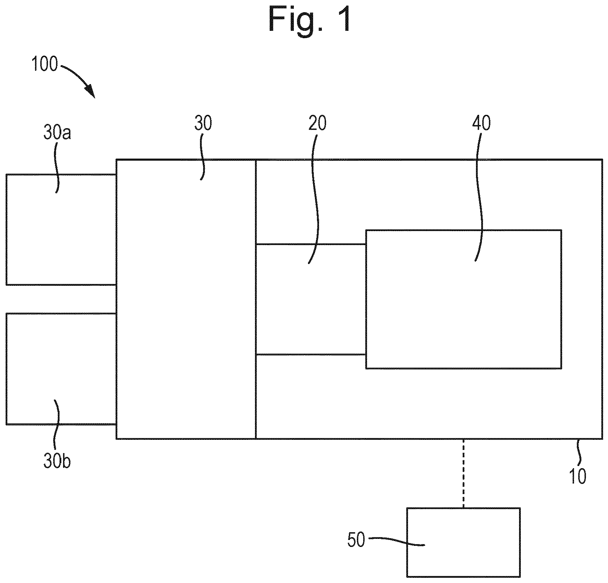

Reference is now made to **FIG. 1****,** which is a schematic diagram illustrating an exemplary charged particle beam assessment apparatus 100, which may also be referred to as a charged particle beam assessment system or simply assessment system. The charged particle beam assessment apparatus 100 of **FIG. 1** includes a main chamber 10, a load lock chamber 20, an electron beam apparatus 40, an equipment front end module (EFEM) 30 and a controller 50. The controller may be distributed between different components of the assessment system, including for example in the electron beam apparatus 40. Electron beam apparatus 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be assessed (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam apparatus by which it may be assessed. An electron-optical apparatus 40 may be configured to direct a multi-beam or a single beam onto the sample 208.

Controller 50 is signally, for example electronically, connected to electron beam apparatus 40, for example as distributed components of the controller 50. Controller 50 may be a processor (such as a computer) configured to control the charged particle beam assessment apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam assessment apparatus or it can be distributed over at least two of the component elements. While the present disclosure provides examples of main chamber 10 housing an electron-optical apparatus, it should be noted that aspects of the disclosure in their broadest sense are not limited to a chamber housing an electron-optical apparatus. Rather, it is appreciated that the foregoing principles may also be applied to other systems and other arrangements of apparatus, that operate under the second pressure.

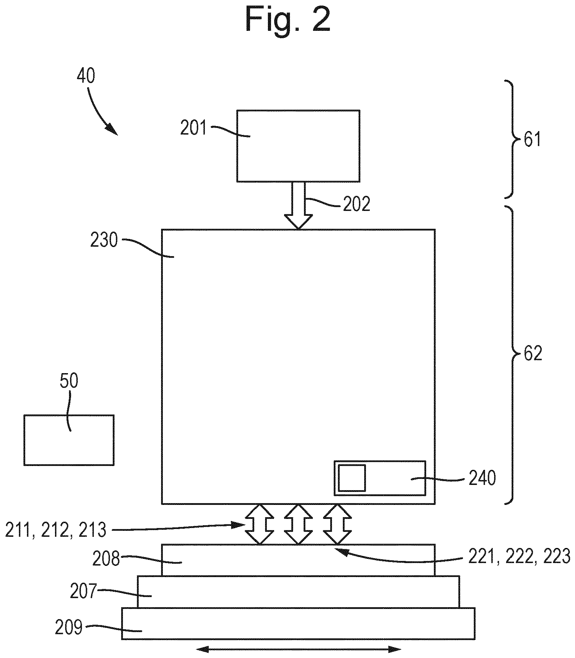

Reference is now made to **FIG. 2****,** which is a schematic diagram illustrating an exemplary electron-optical apparatus 40. The electron-optical apparatus 40 may be provided as part of the exemplary charged particle beam assessment system 100 of **FIG. 1****.** The electron-optical apparatus 40 comprises a source 201 and an electron -optical device (or column) 230. The electron-optical device may direct electrons from the source beam as a plurality of primary beams towards a sample 208. The electron-optical apparatus 40 comprises a sample support that supports a sample 208. The sample support in this example comprises a sample holder 207. The sample holder 207 holds the sample 208 (e.g., a substrate or a mask) for assessment. The sample holder 207 is supported by a motorized or actuated stage 209. The electron beam apparatus 40 further comprises a detector 240. The detector 240 detects signal charged particles (e.g., electrons) from the sample 208. The detector 240 generates detection signals on detection of the signal charged particles.

The electron-optical apparatus 40 may comprise a plurality of modules configured to engage each other. For example, as shown in **FIG. 2****,** a source module 61 may comprise the source 201 and an electron-optical module 62 may comprise at least part of the electron-optical device 230. The source 201 for generating a source beam 202 and associated and component electron-optical elements may be comprised in a source module 61. The source module 61 may comprise some of the electron-optical components of the electron-optical device 230. At least part if not all of the electron-optical device 230 may be comprised in the electron-optical module 62. The electron-optical components of the source module may operate on electrons directed from the source towards the sample 208. The electron-optical module 62 may be for operating on the electrons as they are directed towards the sample. An electron-optical component of the source module 61 and the electron-optical module may respectively operate on the electrons in the form of a source beam 202 or a plurality of primary beams. These modules may be configured to engage each other such that the source module 61 is aligned with respect to the electron-optical module 62. The modules 61, 62 may be configured to align relative to a path of the charged particles from the source to the sample (or system beam path), for example as the path of the source beam 202 or the path of a beam grid of the primary beams.

The source 201 may comprise a cathode (not shown) and an extractor or anode (not shown). During operation, source 201 is configured to emit electrons as primary electrons from the cathode. The primary electrons are extracted or accelerated by the extractor and/or the anode to form the source beam 202.

The electron-optical device 230 may be configured to convert the source beam 202 into a plurality of beams 211, 212, 213 and to direct each primary beam onto the sample 208. Although three primary beams are illustrated for simplicity, there may be many tens, many hundreds, many thousands, many tens of thousands, or even hundreds of thousands (or more) of primary beams. The plurality of primary beams may be referred to collectively as a multi-beam or beam grid for example of primary beams. A beam grid with so many primary beams (e.g. more than a thousand beams) may have a field of view of e.g. more than 0.5mm, for example in the range of 0.5 to 30mm or 1 to 30 mm.

The controller 50 (for example control system comprising distributed controllers) may be connected to various parts of charged particle beam assessment apparatus 100 of **FIG. 1****,** such as the source 201, the detector 240, the electron-optical device 230, and actuated stage 209. The controller 50 may perform various image and signal processing functions. The controller 50 may also generate various control signals to govern operations of the charged particle beam assessment apparatus 100, including operations of the electron-optical apparatus 40.

The electron-optical device 230 may be configured to focus, for example, primary beams 211, 212, and 213 onto a sample 208 for assessment and may form three probe spots 221, 222, and 223 on the surface of sample 208. The electron-optical device 230 may be configured to deflect primary beams 211, 212, and 213 to scan probe spots 221, 222, and 223 across individual scanning areas in a section of the surface of sample 208. In response to incidence of primary beams 211, 212, and 213 on probe spots 221, 222, and 223 on sample 208, electrons are generated from the sample 208 which include secondary electrons and backscattered electrons which may be referred to as signal charged particles. The secondary electrons typically have electron energy as large as fifty electron volts (≤ 50 eV) and backscattered electrons typically have electron energy between fifty electron volts (50 eV) and the landing energy of primary beams 211, 212, and 213.

The detector 240 may send the detection signals generated in the detector 240, for example as an imaging or detection signal, to the controller 50 or a signal processing system (not shown which may be part of the controller 50), e.g. to construct images of the corresponding scanned areas of sample 208. The detector 240 may be incorporated at least partly into the electron-optical device 230 or may be separate therefrom, for example where a secondary optical column directs secondary electrons to the detector 240.

The controller 50 may comprise an image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may be distributed as different components along a datapath between detector elements of the detector and remote computer rack. The image acquirer may receive the detection signal from the detector 240, may process the data comprised in the signal as a dataset. The image acquirer may construct an image therefrom. The image acquirer may thus datasets of the sample optionally in the form of images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more datasets (for example images) of a sample 208 based on a detection signal (optionally as an imaging signal) received from the detector 240. A detection signal may correspond to a scanning operation for conducting charged particle imaging. An acquired dataset (e.g. an acquired image) may be a single dataset image comprising a plurality of datasets from different portions of the sample. The acquired image may be a single image comprising a plurality of imaging areas. The single dataset (e.g. image) may be stored in the storage. The single dataset (or single image) may be an original dataset (e.g. image) that may be divided into a plurality of regions. Each of the regions may comprise one dataset area (e.g. one imaging area) containing a feature of sample 208. The acquired datasets (e.g. images) may comprise multiple datasets (e.g. images) of a single imaging area of sample 208 sampled multiple times over a time period. The multiple datasets (e.g.images) may be stored in the storage. The controller 50 may be configured to perform image processing steps with the multiple datasets (e.g. images) of the same location of sample 208.

The controller 50 may include measurement circuitry (e.g., analog-to-digital converters) to obtain a distribution of the detected secondary electrons. A part of the controller for such a function may be comprised in or proximate to the detector. The electron distribution data, collected during a detection time window, can be used in combination with corresponding scan path data of each of primary beams 211, 212, and 213 incident on the sample surface to reconstruct images of the sample structures under assessment. The reconstructed images can be used to reveal various features of the internal or external structures of sample 208. The reconstructed images can thereby be used to reveal any defects that may exist in and/or on, thus of the sample.

The controller 50 may control actuated stage 209 to move sample 208 during assessment of sample 208, for example to provide a scanning motion of the stage relative to the paths of the primary beams. The controller 50 may enable actuated stage 209 to move sample 208 in a direction such as part of the scanning motion of the stage, such as continuously, for example at a constant speed, at least during sample assessment. The controller 50 may control movement of the actuated stage 209 so that it changes the speed of the movement of the sample 208 dependent on various parameters. For example, the controller may control the stage speed (including its direction) depending on the characteristics of the assessment steps and/or scans of the scanning process for example as disclosed in EPA 21171877.0 filed 3 May 2021 which is hereby incorporated by reference in so far as the combined stepping and scanning strategy at least of the stage. In controlling the actuated stage, actuation of the stage and thus the sample may enable the sample to be positioned, for example dynamically, relative to the paths of the primary beams.

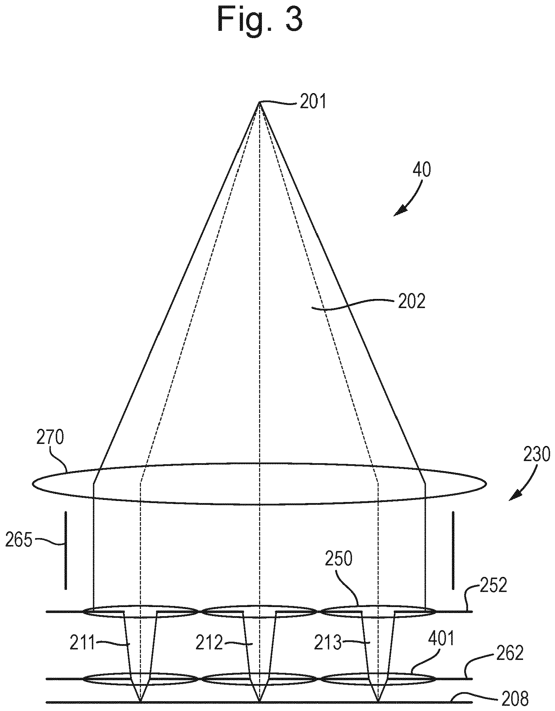

**FIG. 3** is a schematic diagram of an exemplary electron-optical device 230 for use in the electron-optical apparatus 40 of **FIG. 2****.** Features that are the same as those described above are given the same reference numerals. For conciseness, such features are not described in detail with reference to **FIG. 2****.** For example, the source 201 and the sample 208 may be as described above.

The electron-optical device 230 comprises all electron-optical elements that are intended to operate on electrons between the source 201 and sample 208. One or more of the electron-optical elements are electrostatic. One or more of the electron-optical elements may be magnetic. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of electron-optical devices such as those discussed herein, it will be understood that lens arrays will typically operate electrostatically and so may not require any physical elements adopting a biconvex shape. Lens arrays may comprise multiple plates with apertures. Each plate with apertures may be referred to as an electrode. The electrodes may be provided in series along a path of a beam grid of a plurality of primary beams. The electrodes are thus also in series along paths of primary beams of the beam grid.

As shown in **FIG. 3** in an embodiment the electron-optical device 230 comprises a macro collimator 270 and a macro scan deflector 265. The macro collimator 270 and/or the macro scan deflector 265 may be a macro lens that may be magnetic, electrostatic or both. The macro collimator 270 and the macro scan deflector 265 act on the source beam before the source beam is split to form the primary beams. The macro collimator 270 and the macro scan deflector 265 may thus act on all of the source beam rather than comprising arrays of elements configured to interact with different individual portions of the multi-beam.

In the arrangement of **FIG. 3****,** a source beam 202 from the source 201 is split into primary beams 211, 212, 213 by a beam forming array 252 defining an array of beam-limiting apertures. The electron-optical device 230 in this embodiment further comprises a beam shaping aperture array 262 downbeam from the beam forming array 252. The beam shaping aperture array 262 defines an array of beam-limiting apertures. The beam shaping aperture array 262 may shape beams defined by the beam forming array 252. The use of two shaping aperture arrays is beneficial in situations in which use of only the beam forming array 252 risks introducing aberrations into the primary beams. In a variation of the arrangement shown in and described with reference to **FIG. 3****,** the macro scan deflector may be replaced with a scan deflector array associated with the objective lens array and/or the macro condenser lens may be replaced with a collimator deflector array associated with the control lens array and/or the beam forming array 252. In an arrangement the electron-optical device 40 features both the macro condenser lens and the collimator array and/or both of the macro scan deflector and the deflector array.

An objective lens array 401 is provided downbeam from the macro scan deflector 265. The objective lens array 401 comprises an objective lens for each primary beam. The objective lens array 401 directs the primary beams onto the sample 208. The objective lens array 401 may comprise two or more, preferably at least three, plate electrode arrays connected to respective potential sources.

Optionally, a control lens array 250 is provided between the macro scan deflector 265 and the objective lens array 401. The control lens array 250 comprises a control lens for each primary beam. The control lens array 250 provides additional degrees of freedom for controlling properties of the primary beams. The control lens array 250 may comprise two or more, preferably at least three, plate electrode arrays connected to respective potential sources. A function of control lens array 250 is to optimize the beam opening angle with respect to the demagnification of the primary beam and/or to control the beam energy delivered to the objective lenses, each of which directs a respective primary beam onto the sample 208. In an embodiment the control lens array may be considered to be part of the objective lens, for example in being additional plates associated with the objective lens array.

The detector (not shown in **FIG. 3****)** may be provided within the objective lens array or between the objective lens array and the sample 208. The detector may detect signal electrons from the sample 208. The detector additionally or alternatively may have detector elements upbeam along the beam path of the objective lens array 401 or even the control lens array 250. The detector may comprise an array of detector elements (e.g. a detector array). Each element may be associated with an individual primary beam, for example positioned to detect signal particles generated by the individual primary beam.

The electron-optical device 230 of **FIG. 3** may be configured to control the landing energy of electrons on the sample 208 by varying potentials applied to the electrodes of the control lenses and the objective lenses. The control lenses and objective lenses work together and may be referred to as an objective lens assembly. The landing energy can be selected to increase emission and detection of secondary electrons dependent on the nature of the sample being assessed. The detector may be comprised in the objective lens assembly.

The objective lenses can be configured to demagnify the primary beam by a factor greater than 10, desirably in the range of 50 to 100 or more. The objective lenses may comprise three electrodes: a middle electrode, a lower electrode and an upper electrode. The upper electrode may be omitted. An objective lens having only two electrodes can have lower aberration than an objective lens having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the primary beams.

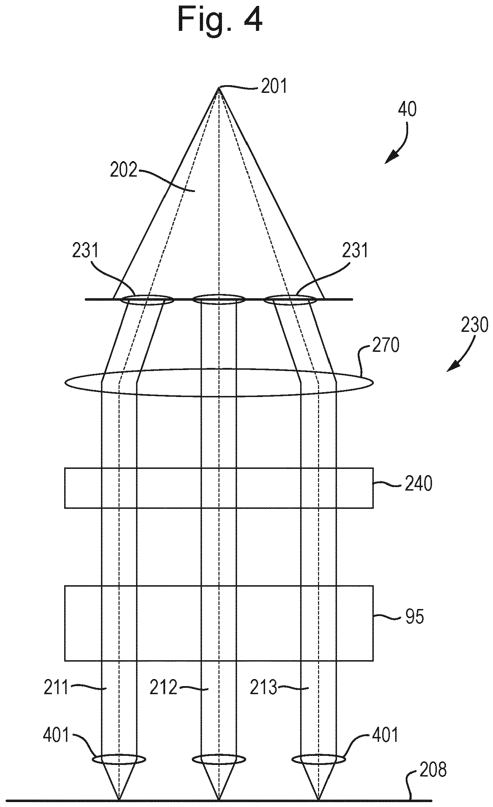

**FIG. 4** schematically depicts a further example of an electron-optical device 230. Features that are the same as those described above are given the same reference numerals. For conciseness, such features are not described in detail with reference to **FIG. 4****.** For example, the source 201, the macro collimator 270, the objective lens array 401 and the sample 208 (e.g., on a sample support 207) may be as described above, except so far as described differently herein.

The source 201 directs electrons as a source beam 202 toward a condenser lens array 231 forming part of the electron-optical device 230. There may be many tens, many hundreds or many thousands or even tens of thousands of condenser lenses in the condenser lens array 231. The condenser lens array 231 may comprise multi-electrode lenses and have a construction based on EP1602121A1, which document is hereby incorporated by reference in particular to the disclosure of a lens array to split an electron beam into a plurality of beams, with the array providing a lens for each beam. The condenser lens array 231 may take the form of at least two, preferably three, plates, acting as electrodes, with apertures in each plate aligned with apertures in other plates to define paths for primary beams through the plates. At least two of the plates are maintained during operation at different potentials to achieve the desired lensing effect. Between the plates of the condenser lens array are electrically insulating plates, for example made of an insulating material such as ceramic or glass, with one or more apertures for the primary beams. Additionally or alternatively, one or more of the plates may feature apertures that each have their own electrode, for example with an array of electrodes around their perimeter or arranged in groups of apertures having a common electrode. In a variant, one or more of the plates may comprise multiple portions or strips with multiple apertures.

In some embodiments, the condenser lens array 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

In another arrangement the condenser lens array 231 may be an 'aperture lens'. The aperture lens may comprise a macro lens element and a beam limiting aperture array to generate the primary beams. The macro lens element may be positioned upbeam of the beam limiting aperture array. The aperture lens may operate to focus the primary beams 211, 212, 213 into an intermediate focus plane.

In an embodiment a deflector array may be used to at least contribute to the collimation of the primary beams, so the deflector array is for finer deflection towards collimation than the action of the macro collimator 270. Such an arrangement may also comprise an array of multiple deflectors (for example in which each aperture has multiple electrodes) for even finer collimation. In an arrangement the condenser lens array 231 may comprise a single plate defining a beam limiting aperture array in which are defined a plurality of apertures with one or more associated macro electrodes with a single aperture. Such a beam limiting aperture array and an associated macro electrode may also form a condenser lens array to focus the primary beams in an intermediate focus which desirably corresponds to the position of the macro collimator 270.

In such an embodiment the macro collimator (which may be electrostatic, magnetic or both) operates on the primary beams 211, 212, 213 rather than the source beam 202. The macro collimator may be located so that its electron-optical plane desirably corresponds to an intermediate focal plane of the primary beams 211, 212, 213 for example caused by operation of the condenser lenses 231 on the different primary beams 211, 212, 213.

In some embodiments the detector 240 is provided between the objective lens array 401 and the sample 208. The detector may face the sample 208. Alternatively, as shown in **FIG. 4****,** the detector 240 may be implemented such that the objective lens array 401 is between the detector 240 and the sample 208.

In an embodiment a separator array 95 is provided between the detector 240 and the objective lens array 401. In an embodiment the separator array 95 comprises a Wien filter array so that separator array 95 may be referred to as a beam separator. The separator array 95 is configured to provide a magnetic field and an electrostatic filed. The separator array 95 may comprises an electrostatic deflector array and a magnetic deflector array. The electrostatic deflector array (or deflector array) applies the electrostatic field. The magnetic deflector array applies the magnetic field. The electrostatic field and magnetic field operate together to separate the charged particles projected as primary beams 211, 212, 213 to the sample 208 relative to the signal particles e.g. electrons from the sample 208. The operation of the fields directs the signal particles towards the detector 240.

In an embodiment the detector 240 is configured to detect signal particles by reference to the energy of the charged particle, i.e. dependent on a band gap, such a semiconductor-based type of detector. Such a detector 240 may be called an indirect current detector. The secondary electrons emitted from the sample 208 gain energy from the fields between the electrodes. The secondary electrons have sufficient energy once they reach the detector 240. In a different arrangement the detector 240 may be an electron to photon converter such as a scintillator array, for example of fluorescing strip between the primary beams that are positioned upbeam along the primary beam path with respect to the Wien filter. Primary beams passing through the Wien filter array (of magnetic and electrostatic strips orthogonal to the primary beam path) have paths upbeam and downbeam of the Wien filter array that are substantially parallel, whereas signal electrons from the sample are directed by the Wien filter array towards the scintillator array. The electron to photon converter may be photonically coupled to a photon to electron converter to convert any photons generated in and emitted by the electron to photon converter. The photon to electron converter may be electrically connected to electronic circuitry to process a detection signal. In different embodiments the photon to electron converter may be within or external to the charged particle device. In an embodiment photon coupling may be by via a photon transport unit (e.g., an array of optical fibers) to a remote optical detector which generates a detection signal on detection of a photon.

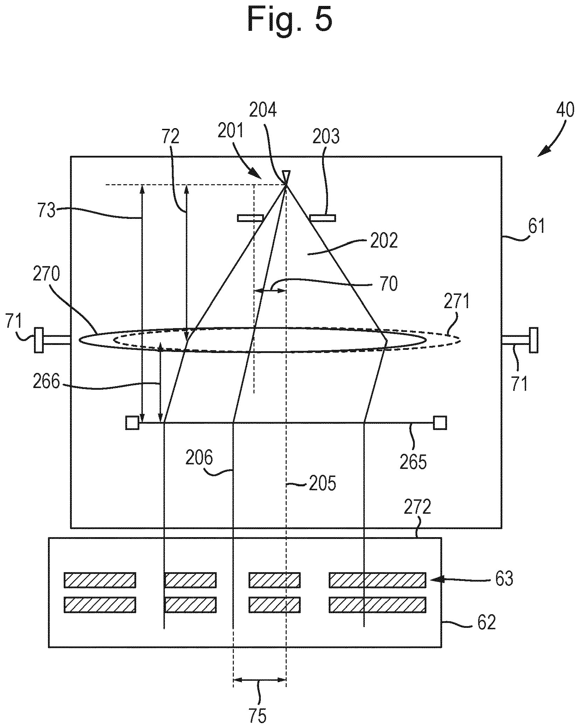

**FIG. 5** is a schematic diagram of an electron-optical apparatus 40. The electron-optical apparatus 40 may have the same features as described above with reference to **FIG. 2** or **FIG. 3** or **FIG. 4****,** for example. For example, the source 201, the macro collimator 270 and the macro deflector 265 may be as described above, respectively.

As shown in **FIG. 5****,** in an embodiment the electron-optical apparatus 40 comprises a module. In an embodiment the module comprises a wall which generally is for a vacuum chamber. In an embodiment the wall of the vacuum chamber is defined by a seal. In use, a volume within the wall of the vacuum chamber is maintained to operate under a vacuum, i.e. a vacuum pressure. For example, the module may comprise one or more components configured to operate at a controlled pressure, for example at a vacuum pressure (i.e. a low pressure). The vacuum chamber may be at least partly defined by the wall. In an embodiment the vacuum chamber is defined by the wall and one or more other surfaces. The one or more other surfaces may be provided separately from the module. The vacuum chamber may be configured to maintain the controlled pressure.

In an embodiment the module is a source module 61. For ease of understanding, embodiments are described in which the module is a source module 61. However, it is not essential for the module to be a source module. For example, the source may be provided separately from the module. The source may be provided in a source module separate from the module. In an embodiment, the module (e.g. the source module 61) comprises the source 201. In an embodiment the source module 61 comprises part of the electron-optical device 230. For example, the source module 61 may comprise the macro collimator 270 and the macro deflector 265.

As mentioned above, in an embodiment the source 201 may comprise an extractor and an emitter 204. Such an emitter 204 and an extractor 203 is shown in **FIG. 5****.** As shown in **FIG. 5****,** in an embodiment the source module 61 comprises the emitter 204 extractor 203. In an embodiment the extractor 203 is configured to extract or accelerate electrons from the emitter 204. The emitter may be controlled to emit electrons by application of the potential between the emitter 204 and the extractor 203, optionally thermally elevating the emitter 204 and on supplying a current to the emitter 204. In an embodiment the source 201 is thereby configured to generate the source beam 202 for example from the electrons emitted by the emitter 204. The source beam 202 may be referred to as a diverging beam for example because the source 201 generates the source beam so it appears to derive from a point source.

As shown in **FIG. 5**, in an embodiment the electron-optical apparatus 40 comprises an actuatable arrangement. The actuatable arrangement may comprise an actuatable electron-optical element. In an embodiment the actuatable electron-optical element is configured to be located outside the wall for the vacuum chamber. The actuatable electron-optical element may be located outside of the vacuum chamber. The actuatable electron-optical element may be located within the source module for example a defining boundary of the apparatus, such as a panel of the apparatus e.g. a panel of the module. In an embodiment the actuatable electron-optical element is configured, in use, to operate under a pressure greater than within the wall of the vacuum chamber. For example, the actuatable electron-optical element is configured, in use, to operate at an ambient pressure such as at atmospheric condition.

In the example shown in **FIG. 5****,** the actuatable electron-optical element comprises the macro collimator 270. In the description below, embodiments are described in which the macro collimator 270 is taken to be an actuatable electron-optical element for example a magnetic electron-optical element. In alternative embodiments, a different electron-optical element may be an actuatable element-optical element. The actuatable electron-optical element is configured to operate on the electrons. For example, the macro collimator 270 may be configured to operate on the electrons as described elsewhere in this document. The electrons may be directed along a beam path towards the sample 208 e.g. as an electron beam such as the source beam 202 and primary beams derived from the source beam 202. The beam path may correspond to an electron-optical axis of the electrons directed towards the sample 208. The beam path may be a system beam path between the source 201 and the sample 208 for example incorporating the beam path of the source beam and the beam path of the beam grid of the primary beams 211, 212, 213. The directing of the source beam may comprise lensing the source beam and/or primary beams by electron-optical components along the system beam path. The directing may comprise operating on the source beam along the beam path of the source beam for example to collimate the source beam. The directing may comprise lensing the primary beams along the beam path of the primary beams by operating electron-optical elements such as focusing of respective primary beams by the objective lenses of an electron-optical assembly (such as the objective lens assembly).

As shown in **FIG. 5****,** in an embodiment the source module 61 comprises the actuatable electron-optical element. In an embodiment the electron-optical device 230 comprises the actuatable electron-optical element. The source module 61 may comprise at least part of the electron-optical device 230 such as the actuatable electron-optical element.

In an embodiment the actuatable electron-optical element is a macro collimator. In such an embodiment the actuatable electron-optical element is an actuatable macro collimator 270. The actuatable macro collimator 270 is configurated to be actuatable relative to the system e.g., the beam path of the source beam 202, as depicted. For example, in an embodiment the actuatable macro collimator 270 is configured to be actuatable in a direction across the beam path. A direction across the beam path may be a horizontal direction in the orientation shown in **FIG. 5****,** or a direction into and out from the plane of the paper in the orientation shown in **FIG. 5****.** Additionally or alternatively, the actuatable macro collimator 270 may be configured to be actuatable relative to the beam path about an axis across the beam path. The axis across the beam path may be in the horizontal direction in the orientation shown in **FIG. 5****,** or into and out from the plane of the paper in the orientation shown in **FIG. 5****.**

In an embodiment the actuatable macro collimator 270 is configured to be actuatable relative to the source 201. For example, in an embodiment the actuatable macro collimator 270 is configured to be actuatable relative to the source 201 in a direction across the source beam 202 and/or about an axis across the source beam 202.

The description may focus on the implementation in which the actuatable macro collimator 270 is actuatable in a direction across the beam path. This is translational motion of the actuatable macro collimator 270. However, it will be understood that actuation about an axis across the beam path is also possible. Actuation about an axis across the beam path is a tilting motion of the actuator macro collimator 270. Therefore reference to actuation of the actuatable macro collimator 270 in a direction across the beam path is considered to encompass actuation about an axis across the beam path, unless stated to the contrary.

In an embodiment actuation of the actuatable macro collimator 270 causes a difference of operation on electrons along the beam path. For example, the movement of the actuatable macro collimator 270 may result in the electrons being deflected differently (e.g. in a different direction) compared to if the actuatable macro collimator 270 were not moved.

In an embodiment the actuatable macro collimator 270 is configured, in use, to operate under atmospheric conditions. In such an arrangement the actuatable macro collimator 270 comprises a macro magnetic lens. The magnetic fields generated by the macro collimator of the actuatable macro collimator 270 is able to pass through the wall of the vacuum chamber into the vacuum chamber. The magnetic fields generated by the macro collimator 270 are able to operate on the electrons along the system beam path. The macro collimator 270 may be referred to as a condenser lens. More generally actuation of the macro collimator 270 has the function of actuation of the path of the electrons e.g. as the source beam 202, i.e. an electron beam actuator. In an embodiment the controller 50 is configured to control actuation of the actuatable macro collimator 270. By controlling the actuation and thus relative positioning of actuatable macro collimator 270 with respect to the system beam path, the controller 50 is configured to control actuation of the path of the electrons e.g. as the source beam 202. The controller controls the actuation of an electron beam actuator on the source beam 202. In an embodiment the controller 50 is configured to control actuation of the actuatable macro collimator 270 so as to introduce an angle in the path of the electrons. That is the controller actuates the electron beam actuator to induce an angle in the path of the electrons for example along the source beam 202. The controller 50 may be configured to control the angle of the paths of the electrons by controlling actuation of the actuatable macro collimator 270.

In an embodiment the controller 50 is configured to compensate for (or correct for) an offset 75 of the paths of the electrons with respect to one or more downbeam electron-optical elements of the electron-optical device 230 for example by applying a correction. For example, in an embodiment the controller 50 is configured to correct for an offset of the source beam 202 with respect to a reference plane on the objective lens array 401, or on the objective lens assembly 63 comprising the objective lens array 401. The reference plane may be any plane for example a component plate of the objective lens assembly, for example the beam forming array 252. In an embodiment the offset is a tilt offset. A tilt offset is an offset about an axis (or a plurality of axes) across the source beam 202. An embodiment of the invention is expected to improve alignment of the electron-optical apparatus 40.

The offset is determined by the path of the electrons (e.g., as the source beam 202) being normally incident on the reference plane. Thus the correction appears to induce a second angle (or counter angle to the first angle), that for example corrects the first angle applied to the path of the electrons. The correction is for counter the angle (for first angle) induced by the actuation of the path of the electron beams by the electron beam actuator (or a first electron beam actuator) in the form of the actuatable macro collimator 270. That is the correction for the angle (or first angle) is applied to the path of the electrons by a second electron beam actuator. The second electron beam actuator actuates the path of the electrons through a second angle (or counter angle to the first angle). The second electron- beam actuator may be located down beam of the first beam actuator.

**FIG. 5** shows an offset 75 in one direction across the source beam 202. In an embodiment, the offset may be in a plane of the two directions for example relative to an origin on the reference plane. The origin may correspond to an interaction with the reference plane of an ideal system beam path (should there be no displacement of the actuatable macro collimator 270 to deflect the electrons of the source beam) or electron-optical axis 205. The two directions may be across the source beam 202. The two directions may be orthogonal to each other. For example, the two directions may be referred to as an X direction and a Y direction. In a different reference frame, the two directions are the radial distance of the offset relative to the origin and azimuthal (or angular) position of the offset relative to the origin about the origin, in the reference plane.

Although the second beam actuator is described to apply a correction, in a different embodiment, the first beam actuator may apply the correction (for example the first angle is a counter angle and/or correction to the second angle). In such an arrangement, the actuatable macro collimator 270 is actuated for example to actuate the electrons of the source beam so the source beam is normal to the reference plane. (Note reference in the rest of this paragraph to the source beam may be considered to be reference to the primary beams of the beam grid). In a further arrangement, the first beam actuator and the second beam actuator are controlled together, for example simultaneous. In such an arrangement the beam actuation by the first beam actuator and the second beam actuator may be considered to be correcting the actuation that the other beam actuator applies to the source beam, or to actuate the beam for a net deflection of the path the source beam, for example so that the path of the source beam is incident to the reference surfaces orthogonally. The first beam actuator and the second beam actuator may be controlled simultaneously or separately. The first beam actuator may be located up beam of the second beam actuator and vice versa. The first beam actuator and the second beam actuator may be referred together as a beam actuator arrangement.

**FIG. 5** does not show any tilt misalignment. However, it will be appreciated that there may be a tilt misalignment about an axis across the source beam 202, for example in a direction across the source beam 202. For example the axis may be an X axis, a Y axis or any axis intermediate the X and Y axes. In an embodiment there may be tilt misalignment about two different axes across the source beam 202. For example the axes may be orthogonal to each other such as an X axis and a Y axis.

**FIG. 5** shows actuation of the actuatable macro collimator 270 as a translational movement of the actuatable macro collimator 270. Additionally or alternatively, the actuatable macro collimator 270 may be actuated as a tilting motion.

The actuatable macro collimator 270 operates under ambient conditions within the assessment apparatus, such as atmospheric conditions such that substantially no vacuum forces apply for example to actuatable macro collimator 270. During use of the electron-optical apparatus 40, the actuatable macro collimator 270 may be movable with a relatively low force because of the absence of the application of vacuum forces. An embodiment of the invention is expected to reduce the actuation forces required to perform alignment of the electron-optical apparatus 40. By reducing the actuation forces required for actuating an actuatable electron-optical component such as the macro collimator 270 such as during alignment, it may be easier to achieve the required accuracy for the intended application, such as alignment. By reducing the actuation forces required to perform a process such as alignment, the process may be performed less manually so at least automatedly, even entirely automatedly. By reducing the actuation force, less deformation of the construction is realized and thus backlash may be reduced. The final position of the actuatable electron-optical component may be more predictable. More automation of the alignment may be enabled.

An embodiment of the invention is expected to make it easier to ensure the position of a center line (or path) of the source beam 202 relative to a center line 206 of an electron-optical assembly (e.g. the objective lens assembly) configured to operate on primary beams derived from the source beam 202. The origin on the reference plane may lie on the center line of the electron-optical assembly.

As shown in **FIG. 5****,** in an embodiment the electron-optical apparatus 40 comprises an electron-optical module 62. The electron-optical module 62 may comprise at least part of the electron-optical device 230. For example, as shown in **FIG. 5****,** in an embodiment the electron-optical module 62 may comprise the objective lens assembly 63. The objective lens assembly 63 comprises the objective lens array 401. In an embodiment, the objective lens assembly 63 may comprise a detector 240 such as the detector array, a control lens array 250, a beam forming array 252 and a beam shaping aperture array 262. In an embodiment the objective lens assembly 63 comprises one or more corrector arrays configured to compensate for one or more aberrations of the primary beams. The objective lens array comprises one or more corrector arrays, for example a plate of the objective lens array may be a plate of a corrector array.

In an embodiment the source module 61 and the electron-optical module 62 are separable from each other. In an embodiment the source module 61 is securable to the electron-optical module 62. For example, the source module 61 may be fixable to the electron-optical module 62. Merely as one example, in an embodiment the electron-optical apparatus 40 comprises one or more bolts configured to secure the source module 61 to the electron-optical module 62. The components of the source module 61 and the electron-optical module 62 may have a common frame of reference in at least the degrees of freedom in which they are secured together. Such components may be the source 201, the first beam actuator (such as the actuatable macro collimator 270), the second beam actuator and the objective lens assembly 63, for example at least the reference plane.

An embodiment of the invention is expected to reduce the amount of manual operation required to perform an alignment operation. By actuation of the macro collimator 270 (which is outside vacuum) and reducing the actuation load of the macro collimator 270, the effort required to reposition the macro collimator 270 may be reduced.

As shown in **FIG. 5****,** in an embodiment the objective lens assembly 63 comprises a plurality of plates. Each plate may comprise a plurality of beam apertures for the passage of primary beams. In an embodiment the objective lens assembly 63 comprises a stack, for example a stack of plates. It should be noted that elements such as objective lenses 401 and separator arrays 95 of the arrangement shown in and described with reference to **FIG. 4** may be provided in a stack of plates such as shown in and described with reference to **FIG. 5****.** The arrangements described with reference to FIG. 3 may thus apply to the arrangements shown in and described with reference to **FIG. 4****.**

However, it is not essential for the electron-optical module 62 to comprise an objective lens assembly comprising a stack of plates. For example, in an embodiment of the arrangement shown in **FIG. 3****,** the alignment process may be performed to align the source beam 202 with an objective lens array 401). In an embodiment of the arrangement shown in and **FIG. 4****,** the alignment process may be performed to align the primary beams 211, 212, 213 with an objective lens array 401. In these embodiments, the objective lens array 401 may be provided independently of a stack of plates.

In an embodiment as shown in **FIG. 4** the objective lens assembly 401 may be associated with the separator array 95. The separator array 95 may be part of a different assembly from the objective lens assembly that comprises the objective lens array 401 such as a separator assembly which houses all components of the separator array 95. Alternatively, the separator array 95 may be part of the objective lens assembly. The alignment process may be for aligning the source beam relative to such an assembly comprising the objective lens array 40. The alignment process may use the separator array 95 as second beam actuator. In an embodiment the electron-optical module 62 comprises the objective lens array 401 and the separator array 95. In a different embodiment the separator array may be comprised in the source module 61.

In an embodiment the source 201 is configured, in use, to operate under vacuum. For example, in an embodiment the source module 61 comprises a vacuum chamber for the source 201. The source 201 is operated in a vacuum environment during use of the electron-optical apparatus 40.

By providing a beam actuator arrangement comprising a first beam actuator such as the actuatable macro collimator 270, an alignment process may be performed by actuating the beam actuator arrangement, such as at least the first beam actuator such as the actuatable macro collimator 270. Actuating the beam actuator arrangement, for example for the alignment process, may comprise actuating the second beam actuator, desirably with the actuation of the first beam actuator. During such actuation for alignment, it may not be necessary to move the source 201. By providing the actuatable macro collimator 270, the alignment process may be performed at least partly while the electron-optical apparatus 40 is under operating conditions. For example, the vacuum environment for the source 201 may be maintained while the alignment process is being performed. This may reduce the requirement for venting the environment (i.e. increasing the pressure above the operating vacuum conditions) in order to perform the alignment. Such alignment after venting may comprise manually adjustment of components of the electron-optical device for example after opening and disassembling the charged particle electron-optical apparatus. An embodiment of the invention is expected to reduce the overall time required for performing an alignment operation. For example, days of time may be saved which would otherwise be required in order to perform the venting, manual adjustment and to reduce the pressure back to vacuum conditions.

By enabling the alignment process to be performed while the source 201 remains under vacuum conditions, the correction of any offset can be measured accurately while performing the correction. For example, in an embodiment the controller 50 is configured to measure an offset of one or more primary beams with respect to an electron-optical assembly (e.g. the objective lens assembly) of the electron-optical device 230. In an embodiment the controller 230 is configured to actuate the beam actuator arrangement, for example the actuatable macro collimator 270 based on the measured offset. An embodiment of the invention is expected to reduce the time required to achieve alignment within the required tolerances. In contrast, if the alignment corrections are performed after the system has been vented, then the system is required to be back in vacuum conditions in order for any offset to be measured accurately. This greatly increases the overall time required to perform the alignment.

In an embodiment the alignment process comprises aligning one or more primary beams with an electron-optical assembly (e.g. the objective lens assembly). The electron-optical assembly may be, for example, the objective lens assembly 63, the objective lens array 401 or another electron-optical element such as the detector 240. In an embodiment the source 201 is secured to the electron-optical assembly to which the one or more primary beams are aligned. In an embodiment the source 201 is secured to the electron-optical assembly via a frame. The frame may be rigid.

As mentioned herein, the source 201 may be secured to the electron-optical assembly (e.g. the objective lens assembly), for example by securing the source module 61 to the electron-optical module 62. The vacuum is ensured by the securing the source module 61 and the electron-optical module 62 together. Thus the offset may be determined, for example measured, after the source 201 is secured the other components of the electron-optical device such the electron optical assembly. The charged particle apparatus may be used after the controller 50 has measured that the offset is within the required tolerances. By determining the offset, the controller 50 may actuate the actuatable macro collimator 270 so as to align the one or more primary beams to the electron-optical assembly. The actuatable macro collimator 270 may be moved while the source 201 is secured to the electron-optical assembly, for example after the source module 61 has been secured to the electron-optical module 62. It is therefore not desirable to separate, for example unsecure (or loosen), the source 201 from the electron-optical assembly in order to implement the alignment process. An embodiment of the invention is expected to reduce the time used for such an alignment process, for example to speed up the alignment process.

In an embodiment the actuatable macro collimator 270 is actuated while a volume within the wall of the vacuum chamber is maintained at a vacuum pressure. It may not be necessary to temporarily change the pressure in order to actuate the actuatable macro collimator 270 such as to perform the alignment process which may be referred to as a method. In an embodiment the method comprises measuring an offset of the one or more primary beams with respect to an electron-optical assembly (e.g. the objective lens assembly) such as reference plane of the electron-optical assembly such as relative to an origin. The method comprises actuating an actuatable arrangement based on the measured offset. The actuatable arrangement may comprise the actuatable electron-optical element such as the actuatable macro collimator 270. In an embodiment, the method comprises, during module assembly, verifying that the offset is below a predetermined threshold. This may be a preliminary step before actuation of the actuatable macro collimator 270.

In an embodiment the measuring comprises detecting the primary beams. For example, the primary beams may be detected using a detector 240 such as a detector array of the electron-optical device 230 or of the actuatable stage 209.

In an embodiment the module (such as the source module 61) comprises an electron-optical deflector. In a different arrangement, the deflector is comprised in a different module from the source and/or the actuatable electron-optical element. The actuatable arrangement may comprise components in the same module, such as the source module 61. In a different arrangement, the actuatable arrangement may comprise components in different modules such as the source module and the electron-optical module. The actuatable arrangement of the module (such as the source module 61) may comprise the electron-optical deflector. The actuatable arrangement may comprise the actuatable electron-optical element and the electron-optical deflector. The actuatable electron-optical element may be a first component of the actuatable arrangement for example between the source and the sample. The electron-optical deflector may be a second component of the actuatable arrangement for example between the source and the sample. In an embodiment the actuatable arrangement is positioned along the beam path (or more generally the system beam path). The first component and the second component may be distanced from each other along the system beam path. The actuatable arrangement may be comprise the beam actuator arrangement. The first component may comprise the first beam actuator. The second component may comprise the second beam actuator.

The electron-optical deflector is configured to deflect the electrons. The deflector may be magnetic and/or electrostatic. For example, in the embodiment shown in **FIG. 5****,** the source module 61 comprises the macro deflector 265. The macro deflector 265 is configured to deflect the source beam 202. For example, the macro deflector 265 may be configured to deflect the source beam 202 upbeam of where the primary beams of the multi-beam are defined from the source beam 202. Alternatively, the macro deflector 265 may be configured to deflect the primary beams downbeam of where the primary beams of the multi-beam is defined from the source beam 202.

The description focusses on embodiments in which the macro deflector 265 is the electron-optical deflector associated with the actuatable electron-optical element (e.g. the actuatable macro collimator 270). That is the electron-optical deflector is the second component of the actuatable arrangement (or the second beam actuator); the actuatable electron-optical element may be the first component of the actuatable arrangement (or the first beam actuator). However, in other embodiments a different type of electron-optical deflector is associated with the actuatable electron-optical element. For example the separator array 95 of an arrangement based on that shown in **FIG. 4** may serve as second component in an actuatable arrangement that also comprises a first component. Such a first component may be an actuatable macro collimator 270 that operates on the primary beams of the beam grid for example that an intermediate focus plane. The actuatable arrangement of the first component and the second component of such an arrangement may be controlled for determining an offset of the beam path the beam grid of the primary beams relative to a reference plane for the objection lens array 401, in a similar manner to the control of the actuatable arrangement of the arrangement shown and described with reference to **FIG. 5** for determine the offset of the source beam 202 with respect of the reference plane of the objective lens assembly 63.

In an embodiment the actuatable arrangement is controlled using the offset 75 to align the primary beams with a reference such the reference plane, e.g. the origin on the reference plane. The reference may be of the electron-optical assembly (e.g. the objective lens assembly). The reference may be a reference plane of the electron-optical assembly. The reference plane may be a plane of an aperture array of the electron-optical assembly. The aperture array may comprise a plate. The plate may be planar. The reference plane (e.g. the plate) may be coplanar with the constituent plates of the of the electron-optical components with the electron-optical assembly, such as the plates of the objective lens array 401 and optionally the detector 240.

In an embodiment the actuatable arrangement is controlled so as to actuate the actuatable arrangement to move a first component of the actuatable arrangement relative to the source 201 and/or the reference plane. The first component may comprise the electron-optical element, e.g. the actuatable macro collimator 270. The actuatable arrangement is controlled so as to cause the first component to operate on the electrons along the system beam path. The operation of the first component may deflect the electrons for example through a first angle for example relative to the reference plane.

The first component may be actuated outside the vacuum chamber. In an embodiment the actuatable arrangement is configured to operate on the electrons upbeam of where the plurality of primary beams are derived from the source beam 202. Alternatively, the actuatable arrangement may be configured to operate on the electrons downbeam of where the plurality of primary beams are derived from the source beam 202.

In an embodiment the actuatable arrangement is controlled so as to operate the second component of the actuatable arrangement to actuate on the path of the electrons such as along the system beam path. The operation of the second component may deflect the electrons for example through a second angle for example relative to the reference plane. The second component may comprise the electron-optical deflector.

In an embodiment the first component is controlled across the beam path so as to angle the beam path. The second component may be controlled to simultaneously deflect the beam path to counter the angle applied by the first component. In other arrangements, the first angle caused by the first component may be caused to counter the angle applied by the second component; the different components may be controlled for a common net angle at the position along he system beam path of the reference plane, which may be orthogonal to the reference plane. As a result, the beam path of the primary beams is incident in a normal direction at an aligned position on the reference. The distance between the first component and the second component allows sufficient leverage for the alignment.

The first component may be actuated relative to the source 201 and/or the reference in a direction across the beam path. The first component may be actuated relative to the source 201 and/or the reference about an axis across the beam path. Such actuation or operation of the first component may cause actuation such as deflection of the path of the electrons, such as the source beam 202. Operation of the second component of the actuatable arrangement may actuate the path of the electrons, for example the source beam. In a variation the second component may be actuated relative to the source 201 and/or the reference about an axis across the beam path; however, in such an arrangement, the second component is an electron-optical element such as a lens e.g. a macro lens and it would not be a deflecting electron-optical component such as deflector 265.

In an embodiment control of the first component and control of the second component cooperate (e.g. one depends on the other). The first component and the second component may deflect respective angles in the beam path with respect to the reference for aligning the source 201 relative to the reference.

As shown in **FIG. 5****,** in an embodiment alignment of the one or more primary beams to the objective lens assembly 63 is performed using a combination of actuation (e.g. mechanical actuation) of the macro collimator 270 with an operation of the macro deflector 265 (e.g. electron-optical actuation of the electrons). The macro deflector 265 may be an electrostatic deflector or a magnetic deflector. It is noted that the mechanical actuation of the first component may result in a deflection and thus electron-optical actuation of the electrons such as the source beam. However, the primary actuation of the first component and the second component are mechanical actuation and electron-optical actuation respectively.

In an embodiment the macro deflector 265 is configured to adjust an angle of the source beam 202. This can help to correct for any tilt offset of the source beam 202 with respect to the objective lens assembly 63.

In an embodiment the controller 50 is configured to control operation of the macro deflector 265. For example, the controller 50 may be configured to correct for a tilt offset by controlling operation of the macro deflector 265.

Additionally or alternatively to a tilt offset, it is possible for the one or more primary beams to be offset in a plane across the source beam 202. This may be referred to as a plane offset or an X, Y offset (where the X and Y directions are used to refer to orthogonal directions that are across the beam path). In an embodiment the controller 50 is configured to control the actuatable macro collimator 270 and the macro deflector 265 so as to compensate for a plane offset.

For example, in an embodiment a plane offset correction of the one or more primary beams can be made using the distance between the actuatable macro collimator 270 and the macro deflector 265. Such a distance may be known from the specifications of the electron-optical device at the time of manufacture subject to occasional intermittent calibration. The distance may alternatively or additionally be measured in a direction along the beam path of the source beam 202. As illustrated in **FIG. 5****,** in an embodiment the controller 50 is configured to actuate the actuatable macro collimator 270 so as to introduce an angle in the source beam (or the primary beams if the actuatable macro collimator 270 is downbeam of here the primary beams are derived from the source beam). In general, a greater angle introduced into the source beam by the actuatable macro collimator 270 leads to a greater shift in the plane (i.e. the X, Y plane). In general, a greater distance between the actuatable macro collimator 270 and the macro deflector 265 leads to a greater shift of the source beam within the plane. A larger or greater distance between the macro collimator 270 and the macro deflector 265 allows for correction of a larger offset.

As shown in **FIG. 5****,** in an embodiment the electron-optical deflector associated with the actuatable macro collimator 270 is downbeam of the actuatable macro collimator 270. However, it is not essential for the electron-optical deflector to be downbeam of the actuatable macro collimator 270. In an alternative embodiment, the electron-optical deflector associated with the actuatable macro collimator 270 is upbeam of the actuatable macro collimator 270.

In an embodiment the actuatable electron-optical element (e.g. the actuatable macro collimator 270 is magnetic. A magnetic electron-optical element may be more easily implemented outside of vacuum conditions. Besides the benefits of having the magnetic field generated by the macro collimator 270 outside the vacuum and the field passing into the vacuum, having the mechanical actuation outside the vacuum is more easily implemented than inside the vacuum.

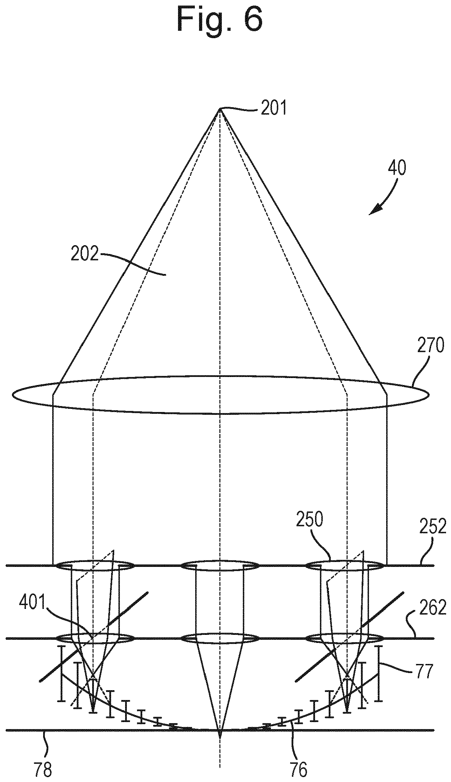

**FIG. 6** is a schematic diagram showing off axis aberrations across the beam grid of the primary beams. Such off-axis aberrations may be field curvature and a stigmatism which may vary in magnitude over the beam grid (or multi-beam). The electron-optical apparatus 40 shown in **FIG. 6** may be of the kind described with reference to figures 2-5, for example. Off axis aberrations such as third order geometrical aberrations of the macro collimator 270 may cause such off-axis aberration such as undesirable field curvature. The field curvature is shown as the curve 76 of focal lengths of the objective lenses of the objective lens array 401. The magnitude of the field curvature aberration shown in **FIG. 6** is exaggerated. Off axis aberrations such as the third order geometrical aberration of the macro collimator 270, may, additionally or alternatively, comprise astigmatism. An astigmatism is shown by the error bars 77 at the bottom of **FIG. 6****.** Additionally or alternatively, third order geometrical aberration of the macro collimator 270 lead to distortion.

By incorporating perturbations to the characteristics of different apertures across an aperture of the different apertures (or plates) of the lens arrays of the electron-optical assembly (e.g. the objective lens assembly) such as the objective lens array and optionally the control lens array, such off-axis aberrations such as astigmatism and field curvature such as across the beam grid, may be reduced if not prevented. In arrangement, the curve 76 may corrected to plane 78, for example as shown in **FIG. 6****.** Such characteristics of the apertures may be the shape (for example the ellipticity), the position relative to a nomination position and relative size of the apertures. Details of such geometrical or hardcoded corrections are disclosed in EP4002421 A1 which is herein incorporated by reference at least with respect to the correction of off-axis aberrations.

Such corrective measures are dependent of the physical perturbations made to the characteristics of the apertures. Such corrective measures are passive; that is the corrections i.e. the physical perturbations are as such not variable during operation of a charged particle apparatus. Such corrections may be considered to be passive correctors. To optimize for example maximize the effectiveness of the correction of the off-axis aberration variable settings which influence their effect should be optimized. One such variable setting is the alignment between the source and the reference plane of the objective lens assembly. By providing an actuation arrangement with at least two components which may be controlled to actuate the path of the electrons from the source to the reference plane, such as featuring an actuatable electron-optical element such as the actuatable macro collimator 270, off-axis aberrations such as field curvature, a stigmatism and/or distortion over the beam grid may be reduced or substantially eliminated. An embodiment of the invention is expected to ensure improved image resolution.

In an embodiment the electron-optical apparatus 40 comprises a corrector configured to correct for aberrations such as off-axis aberrations. For example, the corrector may comprise a corrector array configured to compensate for aberrations of the primary beams. For example, in an embodiment such a corrector is provided in the objective lens assembly 63. In an embodiment the objective lens array 401 comprises a corrector array. For example, corrections may be implemented by controlling the magnitude of characteristics of the position, size and/or ellipticity of individual beam apertures of the objective lens array 401. In an embodiment such a corrector is passive, meaning that the corrector is not adjustable after manufacture of the electron-optical apparatus 40. The validity of the corrections implemented by the corrector rely on a relatively tight tolerance in alignment between the source beam 202 and the objective lens assembly 63 (or other electron-optical assembly) comprising the corrector. An embodiment of the invention is expected to enable the intended accuracy of or even improve the validity of corrections implemented by one or more passive correctors in the electron-optical assembly.

**FIG. 5** shows an offset in the left-right direction. The offset is compensated for by actuation of the source beam 202 of the actuatable macro collimator 270 and the macro deflector 265 (i.e. actuation of the first beam actuator and the second beam actuator of the beam actuation arrangement). The offset 75 is shown as a misalignment between the source beam 202 and the objective lens assembly 63. The offset 75 is compensated for by actuation of the source beam by the beam actuation arrangement. The actuation of the source beam by the beam actuation arrangement is implemented by actuation of the beam by operation of the first beam actuator (e.g. the actuatable macro collimator 270) and the second beam actuator (e.g. operation of the deflector 265). Beam actuation by the actuatable macro collimator 270 is achieved by a translational movement 70 (or actuation) of the actuatable macro collimator 270. The movement 70 is also indicated by the difference between two positions of the macro collimator 270, for example a first position of the macro collimator 270 as shown in solid lines and a second position 271 as shown in dash lines. The first position shows the macro collimator and may be at any position within its range of movement. In the second position 271 the macro collimator operates (e.g. as part of the beam actuator arrangement) to direct the source beam at alignment with the offset 75 at the reference plane 272.

As shown in **FIG. 5****,** the actuatable macro collimator 270 may be located a collimator distance 72 from the source 201. The collimator distance 72 may correspond to the focal length of the macro collimator 270. As shown in **FIG. 5****,** in an embodiment the macro deflector 265 is located a deflector distance 73 from the source 201. The difference between the deflector distance 73 and the collimator distance 72 is the distance between the macro collimator 270 and the macro deflector 265, or actuating distance 266. Across this actuating distance 266, the source beam 202 is angled. In other words, the source beam 202 is not perpendicular to a reference plane of the objective lens assembly 63 for the actuating distance along the beam path, for example the length of the beam path downbeam of the macro collimator 270 and upbeam of the macro deflector 265. The angled path of the source beam of the actuating distance allows for compensation of the offset 75. The macro deflector 265 operates on the beam path, for example deflector distance (i.e. at the down beam end of the actuating distance), to be substantially perpendicular to the reference plane 272 of the objective lens assembly 63.

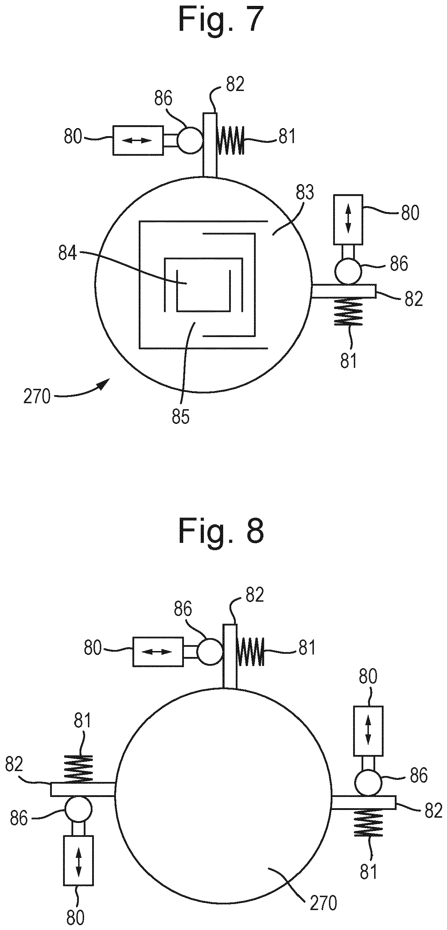

**FIG. 7** is a schematic diagram of an actuatable electron-optical element. **FIG. 7** shows an example in which the actuatable electron-optical element is a macro collimator 270. **FIG. 7** helps to illustrate actuation of the actuatable macro collimator 270. Such an actuatable electron-optical element may comprise an actuating assembly for actuating the actuatable electron-optical element.

As shown in **FIG. 7****,** in an embodiment the module comprises one or more actuators 80. Thus the actuating assembly may comprise one or more actuators 80. Each actuator 80 is configured to actuate the actuatable macro collimator 270. **FIG. 7** shows an example in which two actuators 80 are provided. By providing two actuators 80, the actuatable macro collimator 270 may be actuated, i.e. by the actuators 80, in two respective degrees of freedom. For example, the actuatable macro collimator 270 may be actuated for translational movement along two different (optionally orthogonal) directions across the beam path. Each actuator 80 may be for controlling actuation of the actuatable macro collimator 270 in a respective degree of freedom. The actuatable electron-optical element may configured to be actuatable relative to the beam path in two degrees of freedom in respective directions across the beam path. The directions of the respective degrees of freedom may be angled with respect to each other.

In an embodiment the module comprises three actuators 80, such as shown in **FIG.8** which will be described hereinafter. Thus the actuating assembly may comprise three actuators. The actuators 80 may be configured to operate in respective directions. The directions may be different from each other. In an embodiment one or more of the actuators 80 has a single point of contact with the actuatable electron-optical element. In an embodiment the actuators 80 are configured to actuate the actuatable electron-optical element relative to the actuating assembly, for example the module or an intermediate point such as a mid-point, preferably the centre of the actuatable electron-optical element (rather than relative to the beam path or source, for example).

In the arrangement shown in **FIG. 7****,** there is an actuating assembly comprising two actuators: a first actuator and a second actuator. The actuator 80 at the top of the drawing, e.g. the first actuator, may be configured to actuate the actuatable macro collimator 270 in the left-right direction in the orientation shown in **FIG. 7****,** for example in a first direction across the beam path. The actuator 80 shown on the right hand side of the drawing, for example the second actuator, may be configured to control translational movement of the actuatable macro collimator 270 in the up-down direction in the orientation shown in **FIG. 7****,** for example in a second direction across the beam path. The second direction of actuation is different from the first direction. The first actuator and second actuator may be controlled to achieve actuation in the first direction, the second direction or a combination of components in the first and second direction. Movement of the electron-optical element in a first direction, may be achieved by actuating the first actuator and maintaining the position of the second actuator. The control of the second actuator may ensure that the actuatable electron-optical element moves only in the first direction. Movement of the electron-optical element in the second direction, may be achieved by actuating the first actuator and maintaining the position of the first actuator. The control of the first actuator may ensure that the actuatable electron-optical element moves only in the first direction. Actuation of the first actuator and/or of the second actuator is restricted so that there is substantially none if any rotational component of movement of the actuatable electron-optical element for example about the intermediate point. Actuation of the first actuator and the second actuator may cause translation motion in the first direction and/or the second direction, for example without any rotational movement. **FIG. 7** is a plan view of the actuatable macro collimator 270. In the orientation shown in **FIG. 7****,** the plane of the paper may contain the direction across the beam path.

As shown in **FIG. 7****,** in an embodiment the source module 61 (for example as part of the actuating arrangement) comprises one or more bearings 86 for the respective one or more actuators 80. The bearing 86 may be configured to allow for movements perpendicular to the drive direction of the actuator 80. For example, in **FIG. 7** the actuator 80 shown at the top of the drawing has a drive direction in the left-right direction. The bearing 86 associated with the actuator 80 may allow for the actuatable macro collimator 270 to move perpendicular to the left-right direction. For example, when the actuator 80 shown at the right hand side of the drawing is controlled to drive movement in the up-down direction, then the bearing 86 shown at the top of the drawing may allow for that direction of movement. As shown in **FIG. 7****,** in an embodiment the bearing 86 is a rolling bearing such as a ball bearing. However, it is not essential for the bearing 86 to be a rolling bearing. In an alternative embodiment the bearing 86 is, for example, a plane bearing. More generally, any other mechanical solution that provides a high stiffness in the direction of actuation (for example drive direction) and relatively low stiffness in a direction perpendicular to the direction of actuation may be used. Note: a drive direction may be the first direction for the first actuator and the second direction for the second actuator. Thus a ball bearing may be considered to be embodiment, which may be preferable because it provides a single point of contact.

As shown in **FIG. 7****,** in an embodiment a plurality of actuators 80 are provided. The actuators 80 may have orthogonal drive directions (for example for the first actuator and the second actuator respectively the first direction and the second direction). Alternatively, the drive directions of the actuators 80 may be different from each other but not orthogonal. The drive directions may be oblique to each other.

As shown in **FIG. 7****,** in an embodiment the actuatable macro collimator 270 comprises one or more extensions 82 (for example as part of the actuating arrangement) corresponding to the one or more actuators 80. Each extension 82 may be referred to as a protrusion. The extension 82 is configured to protrude in a radial direction away from a centre of the actuatable macro collimator 270. In an embodiment the extension 82 comprises a surface configured to receive the force from the actuator 80. Interaction between the extension 82 and the respective actuator 80 may influence the movement of the actuatable macro collimator. Actuation of the actuator 80 may cause actuation of the actuatable macro collimator 270 via the extension 82. When one of the actuators 80, such as the first actuator to move the actuatable macro collimator in a first direction, the other of the actuators may control movement such as maintain the position of the actuatable macro collimator in the second direction, for example by control of the second actuator and the interaction between the second actuator and the corresponding extension. 82

In an embodiment the source module 61 comprises a source module body. The source 201 is secured to the source module body. The source module body is configured to have a positional relationship with respect to the beam path. The source module body may comprise a frame for the source module 61. In an embodiment the actuatable macro collimator 270 is mounted relative to the source module body. The macro collimator 270 may be mounted relative to the source module so as to allow for actuation of the actuatable macro collimator 270. For example, the actuatable macro collimator 270 may be mechanically connected to the source module body in such a way as to allow for freedom of movement of the macro collimator 270 translationally across the beam path and/or tilting about axes across the beam path. In an embodiment, the extensions 82 are configured to protrude radially beyond a panel (or an outer wall) of the source module body. In an embodiment the actuators 80 are located outside of the vacuum chamber (for example as defined by the wall of the vacuum chamber), and optionally outside of the source module body for example the panels of the source module body. In an arrangement a part of the actuating arrangement may be located between the wall of the vacuum chamber and the panel of the source module body. A part of the actuating arrangement may be outside of both the vacuum chamber and the panel of the source module body. A part of the actuating arrangement may extend through panel of the source module body, for example through an aperture defined in the panel. In an arrangement a part of the wall and the panel may be the same feature. In a different arrangement a part of the panel may separate from and outside of a part of the wall. The actuators 80 may be located in a region that is under ambient conditions within the charged particle apparatus 40, for example outside the vacuum chamber, during use of the electron-optical apparatus 40. Such ambient conditions may be the ambient conditions within the location in which the electron-optical apparatus is situated which may be atmospheric conditions.

As shown in **FIG. 7****,** in an embodiment the source module 61 comprises more biasing members 81. Thus, the actuating assembly may comprise the biasing members 81. The biasing members 81 may be associated with the respective actuator 80. As shown in **FIG. 7****,** in an embodiment the biasing members 81 are configured to oppose actuation by the respective actuator 80. For example, the actuator 80 shown at the top of **FIG. 7** may drive the extension 82 (and the actuatable macro collimator 270) from left to right, for example the first actuator may actuate the extension in a first direction. The corresponding biasing member 81 may provide an opposing force from right to left, for example in a direction that opposes the first direction. In an arrangement, the actuator determines the position of the collimator for example by determining the position of the respective extension 82. The biasing member 81 is intended to ensure that collimator stays in contact with the actuator for example via the respective extension 81. The collimator may consequently follow the actuation of the actuator 80. For example the biasing member 81 for the first actuator may be considered to apply a counter force to the respective extension 82 in a direction opposing the first direction in which the first actuator operates, the counter force ensures that the first actuator is maintained in contact (for example via the point of contact of the ball bearing 86) with a surface of the respective extension 82. Note that this arrangement has high stiffness in the drive direction, (e.g. the first direction of the first actuator) and substantially no stiffness in a direction perpendicular to the drive direction. The arrangement has substantially no backlash, i.e. a suddenly reversed or backward motion for example caused by resilience within the arrangement. This is because the force between the actuator and its contact with a surface of the respective extension 82 is always in the same direction. In an embodiment the controller 50 is configured to control a drive force of the actuator 80 (so as to control movement of the actuatable macro collimator 270 for example via actuation of the first actuator in the first direction.

As shown in **FIG. 7****,** in an embodiment the biasing members are resilient members such springs, for example coil springs. Alternatively, the biasing members 81 may be any other type of suitable resilient member such as a leaf spring or may comprise an elastic material such as rubber. In a further alternative embodiment, an opposing actuator may be provided to oppose the actuator 80.

In an alternative embodiment, the actuators 80 may be configured to drive the extension 82 in two opposite directions. For example, the top actuator 80 of **FIG. 7** may be configured to drive from right to left or from left to right for example to extend or retract in the first direction, as controlled by the controller 50. The biasing member 81 may be configured to have a pre-tension to keep the extension 82 in contact with the bearing 86 corresponding to the actuator 80.

As shown in **FIG. 7****,** in an embodiment the actuatable macro collimator 270 is provided with an associated restriction plate 83. The restriction plate 83 is configured to restrict movement of the actuatable macro collimator 270 in one or more degrees of freedom. As shown in **FIG. 7****,** in an embodiment the restriction plate 83 comprises an inner part 84 and an outer part 85. In an embodiment the inner part 84 is connected to the outer part 85 via a connection that is compliant for movement in one direction (a first direction) and restrict movement in another direction (a second direction) for example across the beam path. The directions are different. The directions may be orthogonal directions with respect to each other. For example in the arrangement shown in **FIG. 7****,** the connection between the inner part 84 and the outer part 85 comprises longitudinal segments such that the inner part 84 may move relative to the outer part 85 in the left-right directions in the page of the figure, for example the first direction, but may restrict movement in the up-down directions in the page of the figure, for example the second direction. Similarly, the outer part 85 may be connected to the periphery of the restriction plate 83 via a connection that is compliant in one direction for example in a second direction and that restricts movement within the inner part 84 in another direction for example the first direction such as in a direction along the X axis. For example, the outer part 85 is shown as being connected to the periphery of the restriction plate 83 by longitudinal segments that make the outer part 85 compliant to movement of the outer part 85 relative to the periphery in the up-down direction in the page of the figure, for example the second direction such as in a direction along the Y axis but to restrict movement within the outer part 85 in the left-right direction in the page of the figure, for example the second direction. Although each of the inner part 84 and the outer part 85 restrict transmission of the actuation of the actuators 80 in respective directions, the inner part 84 may move with respect to a periphery of the outer part 85 in the second direction. In a frame of reference of the inner periphery of the inner part 84 the outer part may move in the first direction. However, the restrictions to movement of the inner part 84 and the outer part 85 may restrict or prevent rotational movement for example about the beam path (e.g. about Rz) between the periphery of the outer part 84 and the inner periphery of the inner part 85. Actuation through the restriction plate may be limited to actuation in two degrees of freedom such as in the first direction and in the second direction e.g. along the X and Y axes. Actuation about the beam path e.g. around the Z axes is restricted if not prevented.

In an embodiment the inner part 84 of the restriction plate 83 is secured to the actuatable macro collimator 270. For example, the inner part 84 may be connected to the macro collimator 270 for example a coil of the macro collimator. By providing the restriction plate 83, the movement of the actuatable macro collimator 270 may be restricted to movement along the actuating directions (i.e. the left-right directions and the up-down directions) for example in different directions across the beam path, such as in the X and Y axes. The restriction plate 83 may restrict if not prevent rotation of the actuatable macro collimator 270 about an axis along the beam path, such around the z axis. In an embodiment substantially all actuation is done in the intermediate point, desirably the centre of the actuatable macro collimator 270. The intermediate point is desirably the centre of thermal expansion. Actuation of the actuatable electron-optical element, for example the actuatable macro collimator 270, is beneficial with respect to, for example about, the center of thermal expansion. Having the actuation about the center of thermal expansion may reduce if not prevent the impact of thermal drift of the collimator.

In an embodiment the periphery of the restriction plate 83 is mounted relative to the actuatable macro collimator 270. For example, one or more struts may be provided to connect the periphery of the actuatable macro collimator 270 to the periphery of the restriction plate 83.

**FIG. 8** is a schematic diagram of a different arrangement for the actuatable macro collimator 270 that has one or more differences relative to the arrangement shown in and described with reference to **FIG. 7. FIG. 8** shows an actuating arrangement that is different from the actuating arrangement shown in and described with reference to **FIG. 7****.** As shown in **FIG. 8****,** in an embodiment three actuators 80 are provided (for example as part of the actuating arrangement) for actuating the actuatable macro collimator 270. In the arrangement shown in **FIG. 8****,** the actuators 80 are provided for translationally moving the actuatable macro collimator 270 in two degrees of freedom across the beam path for example in two different directions which may correspond to the x and y axes. The actuating arrangement may be capable of rotating the actuatable macro collimator about a direction of the beam path, for example about a Z axis. Features shown in **FIG. 8** that are also shown in **FIG. 7** are not described in detail below. For example, the actuator 80, the bearing 86, the extension 82 and the biasing member 81 may be as described above. The function of the different actuators 80 with respect to their respective extensions 82 may be the same; however, since the actuating arrangement has an additional actuator, for example a third actuator, actuating the actuatable electron-optical element to move the actuatable electron-optical element may differ.

In an embodiment of the arrangement shown in **FIG. 8****,** the controller 50 may be configured to control the actuators 80 so as to substantially prevent rotational movement of the actuatable macro collimator 270. In the arrangement shown in **FIG. 8****,** three actuators 80 are provided for actuating the actuatable macro collimator 270 in two degrees of freedom for example two different directions across the beam path such as in the X and Y axes.

The additional actuator 80 may be used to restrict rotation of the actuatable macro collimator 270. The additional actuator 80 may avoid the need to use the restriction plate 83.
As shown in **FIG. 8****,** the restriction plate 83 shown in **FIG. 7** may be omitted.

In an arrangement, a first actuator may operate in a first direction through contact with a resiliently biased extension 82, such as across the page of **FIG. 8****.** A second actuator and third actuators may also operate respectively in a second direction and a third direction through contact with a respective resiliently biased extension 82. In the arrangement shown in **FIG. 8****,** the second direction and the third direction may be parallel and oppose each other, for example in a direction of the length of the page of **FIG. 8****.** Operation of the first actuator whilst maintaining the positions of the second actuator and the third actuator may causes movement of the actuatable electron-optical element in the first direction. Simultaneous operation of the second actuator and the third actuator to move in a common direction, (so the second actuator may retract in the second direction and the third actuator may extend in the third direction) whilst maintaining the position of the first actuator may cause movement of the actuatable electron-optical element in a direction orthogonal to the first direction. This operation of the actuating assembly shown and depicted in **FIG.8** is exemplary. A different control arrangement may be used for other embodiments of the actuating arrangement for example in which the actuators are located at different azimuthal positions from that depicted. Such other actuating arrangements may achieve the same nature of actuation of the actuatable electron-optical element, for example in different directions (e.g. in the x and y axes) across the beam path without rotational displacement of the electron-optical element.

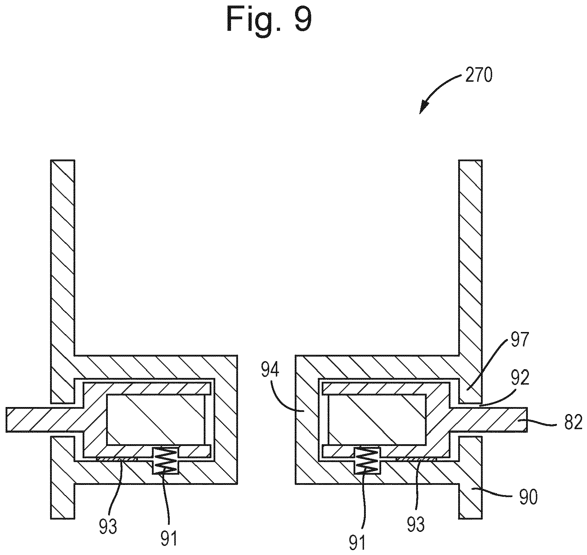

**FIG. 9** is a schematic diagram showing a side-on view of the actuatable macro collimator 270 of **FIG. 8****.** **FIG. 9** helps to show how the actuatable macro collimator 270 engages with the source module body 90 of the source module 61. The representation may also assist in relating the actuatable macro collimator 270 and the actuating assembly to the vacuum chamber, or at least a wall 94 of the vacuum chamber.

As shown in **FIG. 9****,** in an embodiment the actuatable macro collimator 270 (for example the actuating assembly) comprises one or more collimator supports 93. For example, in an embodiment the actuatable macro collimator 270 comprises two, three or more than three collimator supports 93. The collimator supports 93 may be, for example, pads. The collimator supports 93 may be provided at a downbeam side, such as an underside, of the actuatable macro collimator 270. In an embodiment the collimator supports 93 are provided to make contact with the source module body 90. The actuatable macro collimator 270 may be configured to be supported by the collimator supports 93, for example to rest or hang on the collimator supports 93. The collimator supports may provide a connection between the actuatable macro collimator 270 and the source module body with high stiffness. The connection provided by the collimator supports 93 may enable movement of the actuatable macro collimator 270 in the directions in which the actuatable macro collimator 270 is actuated.

As shown in **FIG. 9****,** in an embodiment the source module 61 (for example the actuating assembly) comprises one or more resilient members 91. The resilient members 91 may be, for example, springs or may comprise a elastic material such as rubber. In an embodiment the resilient members 91 are configured to apply a force between the source module body 90 and the actuatable macro collimator 270. The resilient members 91 may be configured to support the mass, such as take part of the weight of, the actuatable macro collimator 270.

In an embodiment the actuatable macro collimator 270 is mounted on the source module body 90 so as to allow for movement during actuation of the actuatable macro collimator 270. For example, the collimator supports 93 may have a sliding contact with a surface of the source module body 90. In an embodiment there is relatively low friction between the collimator supports 93 and the source module body 90 so as to avoid interfering undesirably with actuation of the actuatable macro collimator 270.

In an embodiment the resilient members 91 are configured to reduce the friction force between the actuatable macro collimator 270 and the source module body 90.

As shown in **FIG. 9****,** in an embodiment the source module body 90, such as panel 97 of the source module body 90, comprises one or more openings 92. In an embodiment the extensions 82 are configured to protrude through the openings 92 of the source module body 90, for example in the panel 97.

Although the invention has been described with reference to an assessment system for example a charged particle assessment system, the invention may be applied to any other suitable system. Such modules and a modular assembly comprising at least two adjacent modules may comprise part of an optical or electron optical system or another other system for fabricating a patterned product such as a semiconducting component such as a chip. Such systems may comprise at least one of a lithographic system such as an electron or photon lithographic systems, an assessment system such as a metrology or inspection system or a system for use in track such as a coater, developer or other processing system.

There are provided a number of clauses.

Clause 1. A module for a charged particle-optical device configured to direct one or more primary beams of charged particles toward a sample location along a beam path, the module comprising: a wall for a vacuum chamber; and an actuatable charged particle-optical element configured to operate on charged particles directed along the beam path towards the sample location; wherein the actuatable charged particle-optical element is configured to be located outside the wall for the vacuum chamber and to be actuatable relative to the beam path desirably in a direction across the primary beam and/or about an axis across the primary beam.

Clause 2. The module of clause 1, wherein actuation of the actuatable charged particle-optical element causes a difference of operation on charged particles along the beam path.

Clause 3. The module of clause 1 or clause 2, wherein the actuatable charged particle-optical element is configured to be actuatable relative to the beam path in a direction across the beam path and/or about an axis across the primary beam.

Clause 4. The module of any preceding clause, wherein the actuatable charged particle-optical element is configured, in use, to operate under a pressure greater than within the wall of the vacuum chamber.

Clause 5. The module of clause 4, wherein the actuatable charged particle-optical element is configured, in use, to operate under an ambient pressure.

Clause 6. The module of clause 5, wherein the actuatable charged particle-optical element is configured, in use, to operate under atmospheric conditions.

Clause 7. The module of any preceding clause, wherein, in use, a volume within the wall of the vacuum chamber is maintained at a vacuum pressure.

Clause 8. The module of any preceding clause, comprising: a charged particle-optical deflector configured to deflect the charged particles.

Clause 9. The module of clause 8, wherein the charged particle-optical deflector is magnetic and/or electrostatic.

Clause 10. The module of clause 8 or 9, wherein the charged particle-optical deflector is downbeam of the actuatable charged particle-optical element.

Clause 11. The module of any of clauses 8-10, wherein the charged particle-optical deflector is configured, in use, to operate on charged particles along the beam path.

Clause 12. The module of any preceding clause, comprising: one or more actuators configured to actuate the actuatable charged particle-optical element.

Clause 13. The module of clause 12, comprising: one or more biasing members configured to oppose actuation by the respective one or more actuators.

Clause 14. The module of any preceding clause, wherein the actuatable charged particle-optical element is configured to be actuatable relative to the source in two degrees of freedom in respective directions across the beam path.

Clause 15. The module of clause 14, wherein the directions of the respective degrees of freedom are angled with respect to each other.

Clause 16. The module of any preceding clause, wherein the actuatable charged particle-optical element is configured to be actuatable relative to the source in two degrees of freedom about respective axes across the beam path.

Clause 17. The module of clause 16, wherein the axes are in different directions across the beam path.

Clause 18. The module of clause 17, wherein the respective axes are angled with respect to each other.

Clause 19. The module of any preceding clause, comprising: a module body configured to have a positional relationship with respect to the beam path.

Clause 20. The module of clause 19, wherein the source module body is configured to support the actuatable charged particle-optical element, compliant to the actuation of the actuatable charged particle-optical element relative to the beam path.

Clause 21. The module of any preceding clause, wherein the actuatable charged particle-optical element comprises a lens.

Clause 22. The module of clause 21, wherein the lens comprises a condenser lens and/or a collimator lens.

Clause 23. The module of any preceding clause, wherein the actuatable charged particle-optical element is magnetic.

Clause 24. The source module of any preceding clause, wherein the actuatable charged particle-optical element is configured to operate on charged particles along the beam path.

Clause 25. The module of any preceding clause, wherein the module is a source module comprising: a source configured to generate a source beam of charged particles along the beam path.

Clause 26. The module of any preceding clause, wherein the beam path corresponds to an optical axis of the charged particles directed towards the sample location.

Clause 27. A charged particle-optical device configured to direct a plurality of primary beams of charged particles toward a sample location, the charged particle-optical device comprising: the module of any preceding clause.

Clause 28. The charged particle-optical device of clause 27, comprising: a source configured to generate a source beam of charged particles along the beam path.

Clause 29. The charged particle-optical device of clause 28, wherein the plurality of primary beams derive from the source beam.

Clause 30. The charged particle-optical device of clause 28 or 29, comprising: a charged particle-optical assembly configured to direct one or more primary beams of charged particles derived from the source beam toward the sample location.

Clause 31. The charged particle-optical device of clause 30, wherein the actuatable charged particle-optical element is configured to be actuatable relative to the charged particle-optical assembly in a direction across the source beam and/or about an axis across the source beam.

Clause 32. The charged particle-optical device of clause 30 or 31, wherein the charged particle-optical assembly is configured, in use, to operate under vacuum.

Clause 33. The charged particle-optical device of any of clauses 30-32, comprising: a vacuum chamber for the charged particle-optical assembly.

Clause 34. The charged particle-optical device of clause 33, wherein the vacuum chamber comprises the wall.

Clause 35. The charged particle-optical device of any of clauses 30-34, wherein the source is secured to the charged particle-optical assembly.

Clause 36. The charged particle-optical device of clause 35, wherein the source is secured to the charged particle-optical assembly via a frame.

Clause 37. The charged particle-optical device of any of clauses 30-36, wherein the actuatable charged particle-optical element is located upbeam of the charged particle-optical assembly.

Clause 38. The charged particle-optical device of any of clauses 30-37, wherein the charged particle-optical assembly comprises objective lenses configured to focus the respective one ore more beams onto the sample location.

Clause 39. The charged particle-optical device of any of clauses 27-38, comprising: a vacuum chamber at least partly defined by the wall.

Clause 40. A charged particle-optical apparatus comprising: the charged particle-optical device of any of clauses 27-39.

Clause 41. The charged particle-optical apparatus of clause 40, comprising: an actuatable stage configured to support a sample.

Clause 42. A method for a charged particle-optical device configured to direct one or more primary beams of charged particles toward a sample along a beam path, the method comprising: directing charged particles along the beam path toward a sample; operating on the charged particles with an actuatable charged particle-optical element located outside a wall of the charged particle-optical device, the wall being for a vacuum chamber; and actuating the actuatable charged particle-optical element relative to the beam path.

Clause 43. The method of clause 42, wherein the actuatable charged particle-optical element is actuated while a volume within the wall of the vacuum chamber is maintained at a vacuum pressure.

Clause 44. The method of clause 42 or 43, comprising: measuring an offset of the one or more beams with respect to a charged particle-optical assembly of the charged particle-optical device configured to direct the one or more beams toward the sample; and actuating the actuatable charged particle-optical element based on the measured offset.

Clause 45. The method of clause 44, comprising: securing a source, configured to generate a source beam from which the primary beams are derived, to the charged particle-optical assembly.

Clause 46. The method of clause 45, wherein the source is secured to the charged particle-optical assembly before the actuatable charged particle-optical element is actuated.

Clause 47. The method of any of clauses 42-46, comprising: adjusting a charged particle-optical deflector of the source module configured to deflect the charged particles.

Clause 48. The method of any of clauses 42-47, wherein the actuating of the charged particle-optical element causes a difference in the operating of the actuatable charged particle-optical element along the beam path.

Clause 49. A method for aligning a plurality of primary beams within a charged particle-optical device for directing the plurality of primary beams along a beam path towards a sample location, the primary beams derived from a source beam generated by a source, the method comprising: directing charged particles in a source beam from a source towards a sample location; deriving a plurality of primary beams from the charged particles of the source beam; measuring an offset of the primary beams relative to a reference; and controlling an actuatable arrangement of the charged particle-optical device using the offset to align the primary beams with the reference, the controlling comprising actuating the actuatable arrangement to move a first component of the actuatable arrangement relative to the source and/or the reference.

Clause 50. The method of clause 49, wherein the reference is of a charged particle-optical assembly of the charged particle-optical device, wherein the charged particle-optical assembly is for operating on the primary beams.

Clause 51. The method of clause 50, wherein the reference is a reference plane of the charged particle-optical assembly.

Clause 52. The method of clause 51, wherein the reference plane is a plane of an aperture array of the charged particle-optical assembly.

Clause 53. The method of clause 52, wherein the aperture array comprises a plate.

Clause 54. The method of any of clauses 49-53, wherein the actuating of the first component is outside a vacuum chamber comprising the beam path and the charged particle-optical assembly.

Clause 55. The method of any of clauses 49-54, comprising: operating on the charged particles by the actuatable arrangement upbeam of where the plurality of beams are derived from the charged particles of the source beam.

Clause 56. The method of any of clauses 49-54, comprising: operating on the charged particles by the actuatable arrangement downbeam of where the plurality of beams are derived from the charged particles of the source beam.

Clause 57. The method of any of clauses 49-56, wherein the actuatable arrangement comprises the first component and a second component, wherein the first component and the second component are positioned along the beam path and distanced from each other.

Clause 58. The method of any of clauses 49-57, comprising: controlling the first component across the beam path so as to angle the beam path; and controlling the second component to simultaneously deflect the beam path to counter the angle applied by the first component, so the beam path of the primary beams is incident in a normal direction at an aligned position on the reference.

Clause 59. The method of any of clauses 49-58, wherein the actuating comprises: actuating the first component relative to the source and/or the reference in a direction across the beam path and/or about an axis across the beam path; and/or actuating a second component of the actuatable arrangement.

Clause 60. The method of any of clauses 57-59, wherein the second component comprises a deflector configured to deflect the charged particles along the beam path.

Clause 61. The method of clause 60, wherein the deflecting is performed at a location along the beam path distanced from the first component.

Clause 62. The method of any of clauses 49-62, wherein the controlling comprises cooperating control of the first and second components comprising deflecting respective angles in the beam path of the charged particles from the source with respect to the reference for aligning the source relative to the reference.

Clause 63. The method of clause 61, wherein the distance between the deflecting and the first component allows sufficient leverage for the alignment.

Clause 64. The method of any of clauses 49-63, wherein the first component comprises an actuatable charged particle-optical element.

Clause 65. The method of any of clauses 49-64, wherein the deriving is performed at a charged particle-optical assembly for operating on the primary beams.

Clause 66. The method of any of clauses 49-65, wherein the directing comprises lensing the primary beams.

Clause 67. The method of clause 66, wherein the directing comprises lensing the primary beams by operating objective lenses of a charged particle-optical assembly on respective primary beams.

Clause 68. The method of any of clauses 49-67, wherein the measuring comprises detecting the primary beams.

Clause 69. The method of clause 68, wherein the detecting of the primary beams comprises detecting using a detector array of the charged particle-optical device or of a stage configured to support

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the control lens array 250 and the objective lens array 241.

References to upper and lower, up and down, above and below, etc. should be understood as referring to directions parallel to the (typically but not always vertical) upbeam and downbeam directions of charged particle beams impinging on the sample 208. Thus, references to upbeam and downbeam are intended to refer to directions in respect of the beam path independently of any present gravitational field.

Electron-optics described herein may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electromagnetic field of the compound lens array.

An assessment apparatus, tool or system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment apparatus, tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools).

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and cluases recited herein.

## Claims

1. A module for a charged particle-optical device configured to direct one or more primary beams of charged particles toward a sample location along a beam path, the module comprising:
a wall for a vacuum chamber; and
an actuatable charged particle-optical element configured to operate on charged particles directed along the beam path towards the sample location;
wherein the actuatable charged particle-optical element is configured to be located outside the wall for the vacuum chamber and to be actuatable relative to the beam path.

2. The module of claim 1, wherein actuation of the actuatable charged particle-optical element causes a difference of operation on charged particles along the beam path.

3. The module of claim 1 or claim 2, wherein the actuatable charged particle-optical element is configured to be actuatable relative to the beam path in a direction across the beam path and/or about an axis across the primary beam.

4. The module of any preceding claim, wherein the actuatable charged particle-optical element is configured, in use, to operate under a pressure greater than within the wall of the vacuum chamber.

5. The module of any preceding claim, comprising:
a charged particle-optical deflector configured to deflect the charged particles. the charged particle-optical deflector is configured, in use, to operate on charged particles along the beam path.

6. The module of any preceding claim, comprising:
one or more actuators configured to actuate the actuatable charged particle-optical element.

7. The module of any preceding claim, comprising:
a module body configured to have a positional relationship with respect to the beam path.

8. The module of claim 7, wherein the source module body is configured to support the actuatable charged particle-optical element, compliant to the actuation of the actuatable charged particle-optical element relative to the beam path.

9. The module of any preceding claim, wherein the actuatable charged particle-optical element comprises a magnetic lens, wherein the actuatable charged particle-optical element is configured to operate on charged particles along the beam path, optionally a condenser lens and/or a collimator lens.

10. A charged particle-optical device configured to direct a plurality of primary beams of charged particles toward a sample location, the charged particle-optical device comprising:
the module of any preceding claim.;
a source configured to generate a source beam of charged particles along the beam path. wherein the plurality of primary beams derive from the source beam; and
a charged particle-optical assembly configured to direct one or more primary beams of charged particles derived from the source beam toward the sample location.

11. The charged particle-optical device of claim 10, wherein the actuatable charged particle-optical element is configured to be actuatable relative to the charged particle-optical assembly in a direction across the source beam and/or about an axis across the source beam.

12. The charged particle-optical device of claim 10 or 11, comprising:
a vacuum chamber for the charged particle-optical assembly.

13. The charged particle-optical device of any of claims 10-12, wherein the actuatable charged particle-optical element is located upbeam of the charged particle-optical assembly.

14. The charged particle-optical device of any of claims 10-13, wherein the charged particle-optical assembly comprises objective lenses configured to focus the respective one or more beams onto the sample location.

15. A method for a charged particle-optical device configured to direct one or more primary beams of charged particles toward a sample along a beam path, the method comprising:
directing charged particles along the beam path toward a sample;
operating on the charged particles with an actuatable charged particle-optical element located outside a wall of the charged particle-optical device, the wall being for a vacuum chamber; and
actuating the actuatable charged particle-optical element relative to the beam path.
